Europäisches Patentamt

European Patent Office

Office européen des brevets

(11) Veröffentlichungsnummer: **0 496 934 B1**

# EUROPÄISCHE PATENTSCHRIFT

(45) Veröffentlichungstag der Patentschrift: **12.10.94**

(21) Anmeldenummer: **91114065.5**

(22) Anmeldetag: **22.08.91**

(51) Int. Cl.⁵: **G01B 7/02**, G01R 27/26

(54) Verfahren zum Betreiben eines induktiven Abstandssensors.

(30) Priorität: **30.01.91 DE 4102657**
  **30.01.91 DE 4102655**

(43) Veröffentlichungstag der Anmeldung:
  **05.08.92 Patentblatt 92/32**

(45) Bekanntmachung des Hinweises auf die
  Patenterteilung:
  **12.10.94 Patentblatt 94/41**

(84) Benannte Vertragsstaaten:
  **DE FR GB IT SE**

(56) Entgegenhaltungen:
  **DD-A- 224 970**      **DE-A- 3 345 534**
  **DE-A- 3 516 036**   **DE-A- 3 814 131**
  **US-A- 3 997 835**   **US-A- 4 771 238**
  **US-A- 5 015 948**

  **PATENT ABSTRACTS OF JAPAN vol. 8, no.
  68 (P-264)(1505) 30. März 1984 & JP-A-
  58214825**

(73) Patentinhaber: **VDO Luftfahrtgeräte Werk
  GmbH
  An der Sandelmühle 13
  D-60439 Frankturt (DE)**

(72) Erfinder: **Patzig, Hans Norbert
  Elisabethenstrasse 36
  W-6380 Bad Homburg (DE)**

(74) Vertreter: **Gornott, Dietmar, Dipl.-Ing.
  Zilleweg 29
  D-64291 Darmstadt (DE)**

**Beschreibung**

Die Erfindung bezieht sich auf ein Verfahren zum Betreiben eines induktiven Abstandssensors, bei dem eine erste Spule mit einer definierten Sinusspannung $U_{e1}$ und eine zweite, mit der ersten elektrisch in Reihe geschaltete und im Abstand zu dieser angeordnete Spule mit einer gleich großen, gegenphasigen Sinusspannung $U_{e2}$ beaufschlagt wird,zwischen den Spulen eine Zunge angeordnet ist, die unter Einfluß der Meßgröße ihren relativen Abstand zu den Spulen und damit deren Induktivitäten $L_1$ und $L_2$ ändert und zwischen den Spulen eine Spannung $U_s$ gegen Nullpotential als Nutzsignal abgegriffen wird.

Ein Abstandssensor dieser Art ist aus der europäischen Patentschrift EP-A-0 026 446 bekanntgeworden. Er wird u.a. zur Ermittlung des Beladungszustandes von Flugzeugen benutzt, bei denen von der Durchbiegung der Radachsen oder anderer tragender Bauteile der Fahrwerke auf die Belastung geschlossen wird. Zur Signalauswertung wird entweder direkt die Spannung $U_s$ oder aber deren mit $U_e$ phasengleicher Anteil $U_{se}$ herangezogen. Dabei kann das Meßergebnis nur dann fehlerfrei sein, wenn einerseits die Sinusspannungen $U_{e1}$ und $U_{e2}$ exakt gleich groß und genau gegenphasig sind und andererseits vorausgesetzt werden kann, daß die ohmschen Widerstände in beiden Spulenzweigen genau gleich groß sind und sich mit der Temperatur nicht ändern. Die genannten Voraussetzungen sind in der Praxis nicht gegeben, so daß die mit derartigen Abstandssensoren gewonnenen Signale immer mehr oder weniger fehlerbehaftet sind.

Für Anwendungsfälle, bei denen der Meßfehler nicht größer als +/- 1 % sein darf, ist es daher erforderlich, die potentiellen Fehlerquellen zu analysieren, um nach Möglichkeiten zu suchen, sie zu vermeiden oder zu kompensieren. Der Erfindung liegt die Aufgabe zugrunde, die mit der Verwendung von $U_s$ oder $U_{se}$ als Meßsignal verbundenen Fehler zu vermeiden und Fehler zu kompensieren, die auf die ohmschen Widerstände und deren temperaturbedingte Änderung zurückzuführen und trotz sorgfältiger Herstellung und Abstimmung der Abstandssensoren unvermeidbar sind. Ferner sollen Fehler kompensiert werden, die dadurch entstehen, daß $U_{e1}$ nicht genau gleich $U_{e2}$, daß $U_{e1}$ und $U_{e2}$ nicht um genau 180° phasenversetzt sind und/oder, daß die Sinusspannungen $U_{e1}$ und $U_{e2}$ von einem vorgegebenen Wert abweichen.

Zur Lösung dieser Aufgabe wird erfindungsgemäß vorgeschlagen, daß
- Realteil $U_{eR}$ und Imaginärteil $U_{eL}$ von $U_e = U_{e1}$ plus$U_{e2}$ hinsichtlich Größe und Phasenlage ermittelt werden,
- der mit $U_{eL}$ phasengleiche Anteil $U_{sL}$ von $U_s$ gemessen und

- der im Verhältnis $U_e/U_{eL}$ vergrößerte Wert von $U_{sL}$ für die Signalauswertung benutzt wird.

Zur Lösung der Aufgabe wird ferner vorgeschlagen, daß
- ein Referenzsensor, bestehend aus einem ohmschen Präzisionswiderstandteiler, mit den Sinusspannungen $U_{e1} + U_{e2} = U_e$ beaufschlagt und die Mittelpunktspannung $U_M$ gegen Nullpotential gemessen wird,
- der mit $U_{e1}$ polaritätsgleiche und mit $U_e$ phasengleiche Anteil $U_{MR}$ und der dazu um 90 Grad nacheilende Anteil $U_{ML}$ von $U_M$ ermittelt und abgespeichert werden, danach
- der Abstandssensor mit den Sinusspannungen $U_{e1} + U_{e2} = U_e$ beaufschlagt und von $U_e$ der Realteil $U_{eR}$ und der Imaginärteil $U_{eL}$ sowie der zugehörige Phasenwinkel $\alpha$ ermittelt werden,
- der mit $U_{eL}$ phasengleiche Anteil $U_{sL}$ von $U_s$ gemessen und schließlich
- $U_{sL}$ durch Subtrahieren von $\Delta U_{sL} = U_{MR} \times \sin \alpha + U_{ML} \times \cos \alpha$ korrigiert wird.

Zur Ermittlung des Realteils $U_{eR}$ und des dazu um 90 Grad phasenverschobenen Imaginärteils $U_{eL}$ können die Nulldurchgänge des zu $U_e$ gehörenden Stroms $I_e$ benutzt werden. Alternativ kann man die Nulldurchgänge von $U_e$ dazu benutzen, den zu $U_e$ phasengleichen und den dazu um 90 Grad phasenverschobenen Stromanteil zu ermitteln, aus den Stromanteilen den Winkel $\alpha$ der Phasenverschiebung zwischen $U_e$ und $I_e$ bestimmen und zur Ermittlung von $U_{eR}$ und $U_{eL}$ heranziehen. Schließlich kann man zur Bestimmung von $U_{eR}$ und $U_{eL}$ auch die Phasenverschiebung der Nulldurchgänge zwischen $U_e$ und $I_e$ als $\Delta t$ messen und daraus den Winkel $\alpha$ bestimmen. Das erfindungsgemäße Verfahren eignet sich darüber hinaus zur Kompensation der Einflüsse temperaturabhängiger mechanischer Größen auf das Meßergebnis, indem das bei einer Temperatur $t_x$ gemessene Verhältnis $(U_{eL}/U_e)_x$ mit einem bei einer Referenztemperatur $t_0$ gemessenen Verhältnis $(U_{eL}/U_e)_0$ verglichen und dabei festgestellte Unterschiede berücksichtigt werden.

Mit einem weiteren Abgriff H am Referenzsensor kann man darüber hinaus noch Fehler kompensieren, die daraus resultieren, daß die Sinusspannungen $U_{e1}$ und $U_{e2}$ von dem vorgegebenen Wert abweichen, weil man den Aufwand für eine konstante Spannungsversorgung aus wirtschaftlichen Gründen nicht beliebig steigern kann. Dazu wird die Spannung $U_H$ gegen Nullpotential gemessen und der mit $U_e$ phasengleiche Anteil $U_{HR}$, vermindert um $U_{MR}$, mit einer als Zahlenwert vorliegenden, konstanten Referenzspannung $U_K$ verglichen und zur Bildung eines Faktor $U_K / (U_{HR}-U_{MR})$ herangezogen, der dann zur Normierung von $(U_{sL}-\Delta U_{sL})$ dient.

Weitere Einzelheiten werden anhand der Figuren 1 bis 9 näher erläutert.

Figur 1      zeigt das Prinzipschaltbild des induktiven Abstandsmessers,

Figur 2      zeigt das ideale Zeigerdiagramm der Schaltung,

Figur 3a      zeigt das Zeigerdiagramm für nicht gleichgroße ohmsche Widerstände,

Figur 3b      zeigt das Zeigerdiagramm für nicht gleichgroße ohmsche Widerstände bei einer um 250 K höheren Temperatur,

Figur 4      zeigt den Spannungsverlauf $U_e$, $U_{eR}$ und $U_{eL}$,

Figur 5      zeigt das Zeigerdiagramm $U_e/I_e$,

Figur 6      zeigt die Phasenverschiebung $U_e$ und $I_e$, Figur 7 zeigt das Prinzipschaltbild des induktiven Abstandsmessers mit Präzisionsspannungsteiler,

Figur 8      zeigt das Zeigerdiagramm für nicht ideale $U_{e1}$ und $U_{e2}$,

Figur 9      zeigt das Zeigerdiagramm für die Normierung des Nutzsignals.

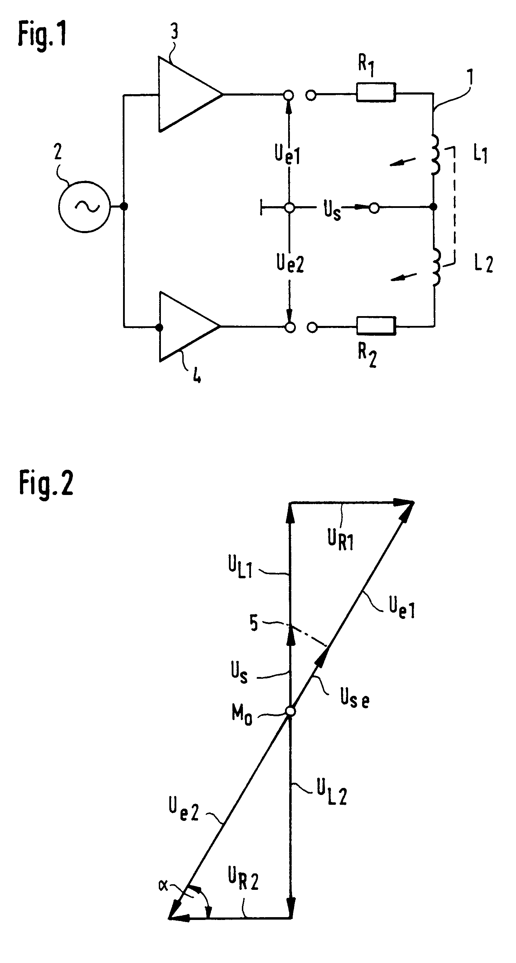

Der induktive Abstandssensor 1 gemäß Figur 1 umfaßt zwei in Reihe geschaltete Spulen mit den Induktivitäten $L_1$ und $L_2$ und den zugehörigen ohmschen Widerständen $R_1$ und $R_2$. Die beiden Spulenzweige werden von einer Wechselspannungsquelle 2 über Verstärker 3 und 4 mit den sinusförmigen Wechselspannungen $U_{e1}$ und $U_{e2}$ angesteuert, die zueinander um 180 Grad phasenversetzt sind. Zwischen den Spulen wird das Nutzsignal $U_s$ gegen Nullpotential abgegriffen. Durch eine im Abstandssensor zwischen den Spulen angeordnete (in Figur 1 nicht dargestellte) Zunge, die unter dem Einfluß der Meßgröße (Scherung, Biegung) ihren relativen Abstand zu den Spulen ändert, werden die Induktivitäten $L_1$ und $L_2$ gegensinnig verändert, so daß ein Nutzsignal $U_s$ gewonnen wird, das der Induktivitätsänderung beider Spulen entspricht.

Figur 2 zeigt das Zeigerdiagramm zu der Schaltung nach Figur 1, das sich unter folgenden Bedingungen ergibt:

$U_{e1}$ genau gleichgroß wie $U_{e2}$

$U_{e1}$ genau gegenphasig zu $U_{e2}$

$R_1$ genau gleich $R_2$

$R_1$, $R_2$ temperaturunabhängig

Unter diesen Bedingungen sind die aus $U_{e1}$, $U_{e2}$ und den zugehörigen Real- und Imaginäranteilen $U_{R1}$, $U_{R2}$ und $U_{L1}$, $U_{L2}$ gebildeten Dreiecke deckungsgleich und es gelten - mit gleichbleibendem Winkel $\alpha$ - die Beziehungen $U_L = U_e \times \sin \alpha$ sowie $U_R = U_e \times \cos \alpha$, mit $U_{eL} = U_{L1} + U_{L2}$, $U_{eR} = U_{R1} + U_{R2}$ und $U_e = U_{e1} + U_{e2}$.

Das Nutzsignal $U_s$, das die Auslenkung der Zunge aus der Mittellage und die dadurch verursachte "Verstimmung" von $L_1$ und $L_2$ wiedergibt, ist immer vom Mittelpunkt $M_o$ zwischen $U_{e1}$ und $U_{e2}$ zu einem Punkt 5 zu messen, der je nach Größe der "Verstimmung" mehr oder weniger weit vom Mittelpunkt entfernt auf $U_L$ liegt. Unter den genannten idealen Bedingungen liegt auch der Mittelpunkt von $U_e$ auf $U_{eL}$, d.h. daß $U_s$ phasengleich mit $U_{eL}$ ist.

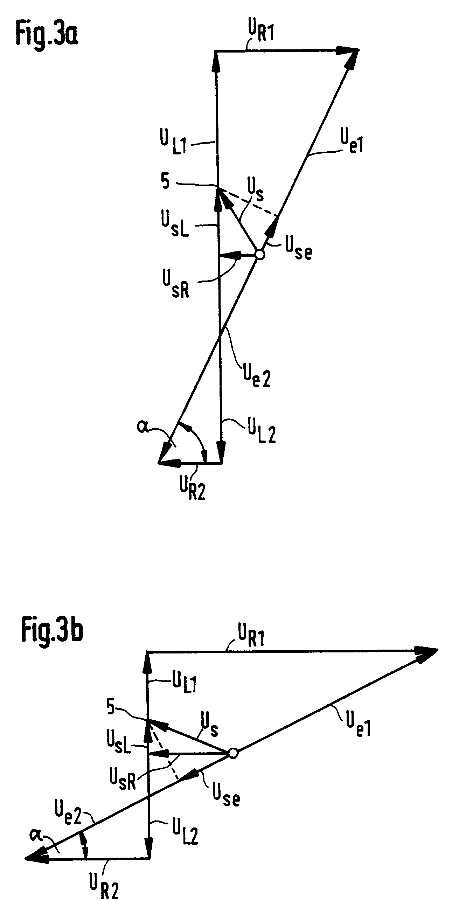

Ist $R_1$ nicht genau gleich $R_2$, dann ergibt sich ein Zeigerdiagramm gemäß Figur 3a. Man sieht, daß der Mittelpunkt von $U_e$ nicht mehr auf $U_{eL}$ liegt und daß $U_s$ dementsprechend auch nicht mehr phasengleich zu $U_L$ ist. Nach dem Stand der Technik hat man sich darauf verlassen, daß zwischen $R_1$ und $R_2$ keine nennenswerten Unterschiede bestehen und daß man mit $U_s$ ein fehlerfreies Signal erhält. Ein weiterer Fehler resultiert daraus, daß aus meßtechnischen Gründen nicht $U_s$ sondern vielfach der mit $U_e$ phasengleiche Anteil $U_{se}$ von $U_s$ zur Auswertung herangezogen wird. Repräsentativ für die Auslenkung der Zunge, d.h. für die Meßgröße kann aber nur $U_{sL}$ sein, ein Wert der meßtechnisch nicht ohne weiteres zu erfassen ist. Erfindungsgemäß werden daher zunächst Realteil $U_{eR}$ und Imaginärteil $U_{eL}$ von $U_e$ nach Größe und Richtung ermittelt.

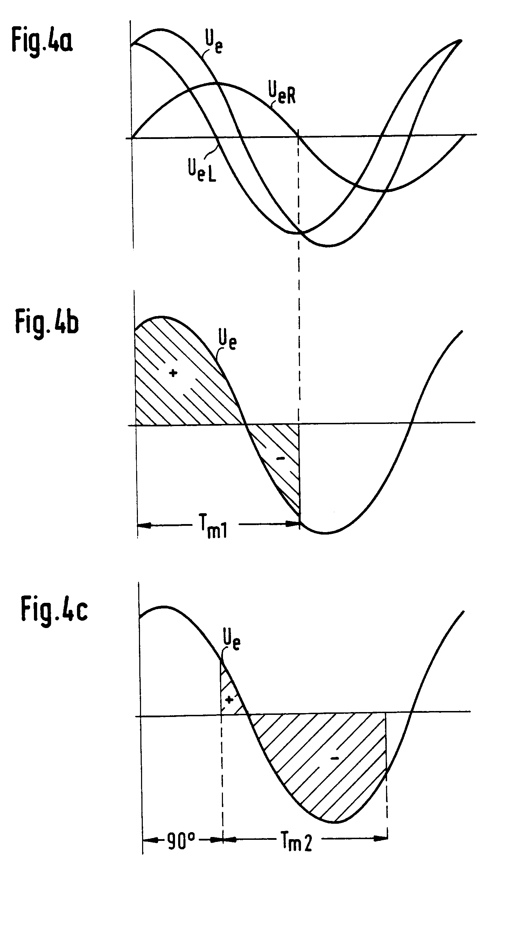

Gemäß Figur 4 setzt sich die Spannung $U_e$ aus einer mit dem Strom $I_e$ phasengleichen Anteil $U_{eR}$ und einem dazu um 90 Grad phasenverschobenen Imaginärteil $U_{eL}$ zusammen. Die Nulldurchgänge von $U_{eR}$ fallen mit den Nulldurchgängen von $I_e$ zusammen, so daß man mit einem durch die Nulldurchgänge von $I_e$ limitierten Meßfenster $T_{m1}$ den Anteil $U_{eR}$ ermitteln kann. Mit dem in gleicher Weise limitierten, aber um 90 Grad phasenverschobenen Meßfenster $T_{m2}$ läßt sich auch der Anteil $U_{eL}$ meßtechnisch feststellen. Das Meßfenster $T_{m2}$ wird auch benutzt, um den zu $U_{eL}$ phasengleichen Anteil $U_{sL}$ von $U_s$ zu bestimmen.

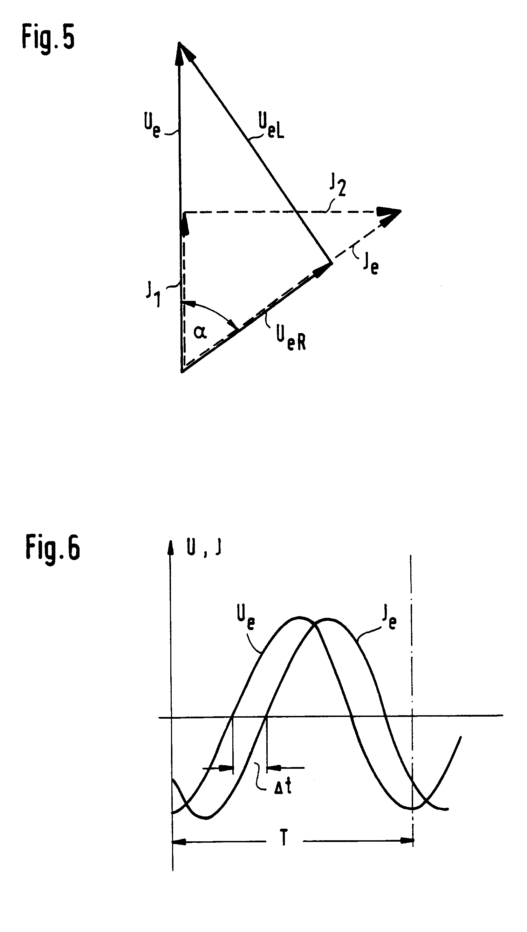

In ähnlicher Weise kann man auch von den Nulldurchgängen von $U_e$ ausgehen, mit einem Meßfenster den mit $U_e$ phasengleichen Anteil $I_1$ von $I_e$ sowie den dazu um 90 Grad phasenverschobenen Anteil $I_2$ von $I_e$ ermitteln und damit den Winkel $\alpha$ sowie die Anteile $U_{eR}$ und $U_{eL}$ nach Größe und Phasenlage bestimmen (Figur 5).

Schließlich kann man gemäß Figur 6 auch die Phasenverschiebung der Nulldurchgänge zwischen $U_e$ und $I_e$ als $\Delta t$ und die Periodendauer $T$ messen und zur Berechnung von $\alpha$ heranziehen ($\alpha = 360 \times \Delta t/T$).

Alle genannten Methoden beruhen auf der Feststellung von Nulldurchgängen und benutzen die bekannten Verhältnisse zwischen $U_e$, $U_{eR}$ und $U_{eL}$ und den zugehörigen Winkelfunktionen. Man kann daher im Einzelfall entscheiden, welche der genannten Methoden oder welche dazu äquivalente Methode am zweckmäßigsten benutzt werden soll, um den gesuchten Anteil $U_{sL}$, d.h. den mit $U_{eL}$

phasengleichen Anteil von $U_s$ zu bestimmen.

Berücksichtigt man außerdem die unvermeidbare Temperaturabhängigkeit der ohmschen Widerstände der Spulen gemäß Figur 3b, dann werden die durch die Benutzung von $U_s$ bzw. $U_{se}$ verursachten Fehler noch deutlicher. Dargestellt ist für gleichbleibende $U_{e1}$ und $U_{e2}$ eine Verdoppelung der Realanteile $U_{R1}$ und $U_{R2}$, was einer Verdoppelung der ohmschen Widerstände und einer erheblichen Verkleinerung des Winkels $\alpha$ entspricht. Die zur Verdeutlichung der Fehlereinflüsse gewählte große Änderung gegenüber Figur 3a ist durchaus realistisch. Sie ergibt sich für Kupferspulen mit einem Temperaturkoeffizienten von 0,4 %/K bei einer Temperaturänderung um 250 K, also beispielsweise für einen Anwendungsbereich des Abstandssensors von -50 bis +200° C.

Nach der Beziehung $U_{eL}^2 + U_{eR}^2 = U_e^2$ wird $U_{eL}$ bei gleichem $U_e$ umso kleiner je größer $U_{eR}$ wird. Dementsprechend verringert sich die maßgebende Ansteuerspannung $U_{eL}$ für die Spule mit steigender Temperatur, so daß bei gleicher Auslenkung der Zunge ein zu kleiner Wert $U_{sL}$ gemessen würde. Auch der vielfach für die Auswertung benutzte Wert $U_{se}$ wird durch die Temperaturabhängigkeit der ohmschen Widerstände stark beeinflußt und kann deshalb kein brauchbares Signal abgeben.

Erfindungsgemäß wird daher außerdem vorgeschlagen, den mit der Phasenlage von $U_{eL}$ bestimmten Anteil $U_{sL}$ noch mit $U_e / U_{eL}$ zu vergrößern. Damit wird der Temperatureinfluß auf den maßgebenden Imaginäranteil der Ansteuerspannung für die Spulen kompensiert und der als Nutzsignal ermittelte Anteil $U_{sL}$ von $U_s$ quasi immer auf die temperaturunabhängige komplexe Ansteuerspannung $U_e$ bezogen.

Mit dem beanspruchten Verfahren wird der bei herkömmlichen Meßmethoden mit der Verwendung von $U_s$ bzw. von $U_{se}$ verursachte Fehler vermieden, und es werden alle Fehlereinflüsse, die auf die ohmschen Widerstände zurückgehen, kompensiert. Damit erhält man ein Nutzsignal, das den geforderten Genauigkeitsansprüchen wesentlich besser genügt.

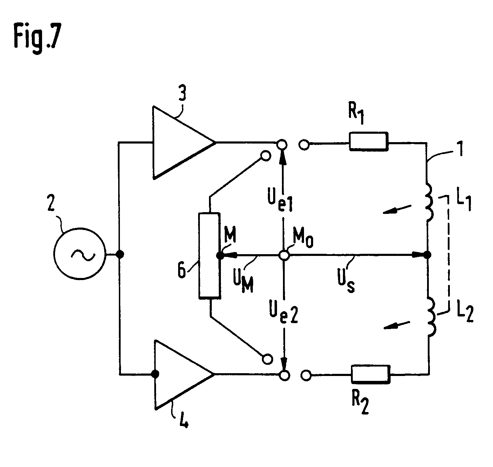

Eine weitere Fehlerquelle ergibt sich, wenn $U_{e1}$ und $U_{e2}$ vom Idealzustand abweichen. Zur Kompensation dieses Fehlers wird ein Präzisionsspannungsteiler benutzt. Der induktive Abstandssensor 1 gemäß Figur 7 umfaßt zwei in Reihe geschaltete Spulen mit den Induktivitäten $L_1$ und $L_2$ und den zugehörigen ohmschen Widerständen $R_1$ und $R_2$. Die beiden Spulenzweige werden von einer Wechselspannungsquelle 2 über Verstärker 3 und 4 mit den sinusförmigen Wechselspannungen $U_{e1}$ und $U_{e2}$ angesteuert, die zueinander um 180 Grad phasenversetzt sind. Zwischen den Spulen wird das Nutzsignal $U_s$ gegen Nullpotential abgegriffen.

Durch eine im Abstandssensor zwischen den Spulen angeordnete (in Figur 1 nicht dargestellte) Zunge, die unter dem Einfluß der Meßgröße (Scherung, Biegung) ihren relativen Abstand zu den Spulen ändert, werden die Induktivitäten $L_1$ und $L_2$ gegensinnig verändert, so daß ein Nutzsignal $U_s$ gewonnen wird, das der Induktivitätsänderung beider Spulen entspricht. Mit 6 ist ein Präzisionsspannungsteiler bezeichnet, der als Referenzsensor dient und mit dem die Mittelpunktspannung $U_M$ festgestellt werden kann, wie noch zu erläutern ist.

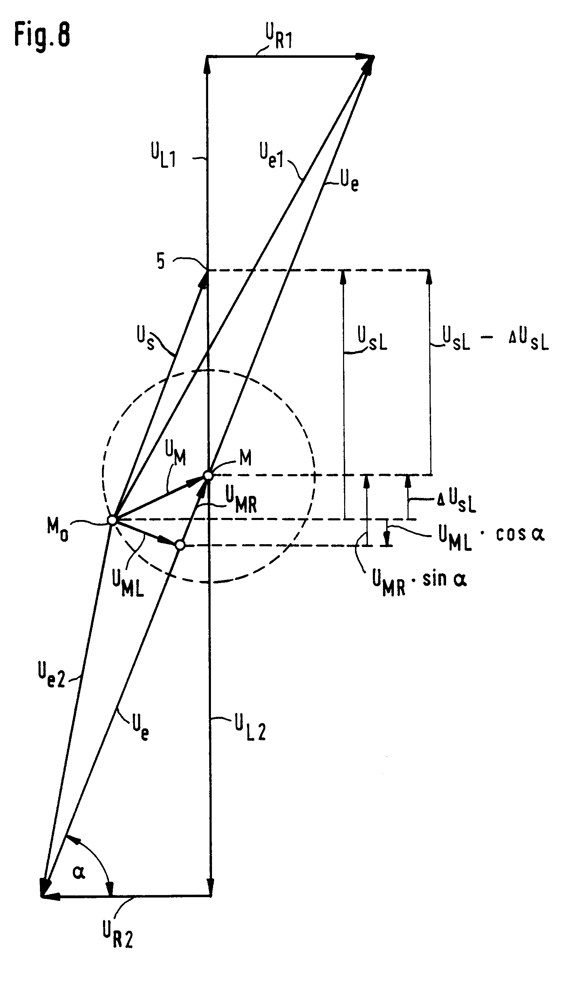

Ist $U_{e1}$ nicht genau gleich $U_{e2}$ und ist deren Phasenlage nicht genau um 180° versetzt, dann ergibt sich ein Zeigerdiagramm gemäß Figur 8. Aus $U_{e1}$ und $U_{e2}$ ergibt sich eine Gesamtspannung $U_e$, deren Mittelpunkt M nicht bekannt ist. Man kann diesen Mittelpunkt erfindungsgemäß aber meßtechnisch ermitteln, indem man die Sinusspannungen $U_{e1}$ und $U_{e2}$ an einen Präzisionswiderstandteiler anlegt. Damit hat man einen Referenzsensor, der die Gesamtspannung $U_e$ in gleichgroße Anteile aufteilt und die Messung einer Mittelpunktsspannung $U_M$ gegen Nullpotential erlaubt. Mit dem gestrichelten Kreis ist in Figur 8 eine Fläche markiert, auf der $M_0$ mit Bezug auf M liegen kann, die also repräsentativ ist für durch fehlerhafte $U_{e1}$ und $U_{e2}$ mögliche Ungenauigkeiten des Meßsignals.

Da es sich beim Referenzsensor um einen rein ohmschen Widerstand handelt, entspricht der mit $U_e$ phasengleiche Anteil $U_{MR}$ von $U_M$ dem Größenunterschied zwischen $U_{e1}$ und $U_{e2}$ und der um 90 Grad nacheilende Anteil $U_{ML}$ dem Winkelfehler zwischen $U_{e1}$ und $U_{e2}$. $U_{MR}$ und $U_{ML}$ werden erfindungsgemäß ermittelt und in einem Datenspeicher abgelegt.

Danach wird der Abstandssensor mit den Sinusspannungen $U_{e1}$ und $U_{e2}$ beaufschlagt und es werden Realteil $U_{eR}$ und Imaginärteil $U_{eL}$ von $U_e$ ermittelt. Außerdem wird der zugehörige Phasenwinkel $\alpha$ festgestellt. Daraus ergibt sich die Möglichkeit, auch den mit $U_{eL}$ phasengleichen Anteil $U_{sL}$ des Nutzsignals $U_s$ zu messen. Dieser Wert ist wegen der fehlerhaften $U_{e1}$ und $U_{e2}$ im dargestellten Beispiel um $\Delta U_{sL}$ zu groß und muß noch entsprechend korrigiert werden. Das fehlerfreie Meßsignal entspricht nämlich nur der Strecke zwischen M und Punkt 5. Anders ausgedrückt, die echte Nullage der Zunge ergibt sich, wenn Punkt 5 und M zusammenfallen. Demnach läßt sich aus den zuerst gemessenen Werten $U_{MR}$ und $U_{ML}$ dem Phasenwinkel $\alpha$ der Korrekturwert wie folgt bestimmen:

$$\Delta U_{sL} = U_{MR} \times \sin \alpha + U_{ML} \times \cos \alpha$$

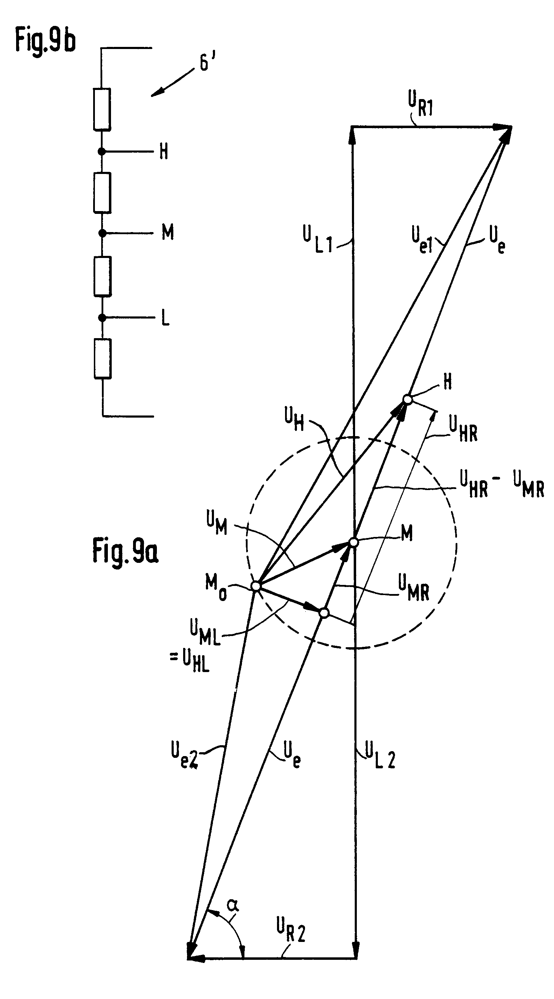

Bei dem bisher beschriebenen Verfahren wurde davon ausgegangen, daß die Spannungsversorgung des Abstandssensors zwar fehlerhaft aber stabil ist und insbesondere, daß $U_{e1}$ und $U_{e2}$ dem Betrage nach einem vorgegebenen Wert entsprechen. Ist diese Voraussetzung nicht erfüllt, muß noch eine Möglichkeit geschaffen werden, die Spannung $U_{e1}$ (und/oder $U_{e2}$) mit einer konstanten Spannung zu vergleichen und das bereits korrigierte Meßsignal zu normieren. Dazu ist der Referenzsensor 6' in Figur 9 mit zwei weiteren Abgriffen H und L versehen, die zueinander symmetrisch sind. Die Ausführungen zum Angriff H gelten daher gleichermaßen für den Angriff L.

Im Zeigerdiagramm der Figur 9 ist außer den aus Figur 8 bekannten Spannungen $U_e$, $U_{e1}$, $U_{e2}$, $U_{R1}$, $U_{R2}$, $U_{L1}$, $U_{L2}$, $U_M$, $U_{MR}$ und $U_{ML}$ noch eine Spannung $U_H$ eingezeichnet, die zwischen dem Abgriff H am Referenzsensor und dem Nullpotential $M_o$ gemessen wird. Sie umfaßt den mit $U_e$ phasengleichen Anteil $U_{HR}$ und den dazu senkrechten Anteil $U_{HL}$, der mit $U_{ML}$ zusammenfällt. Erfindungsgemäß wird die Differenz $U_{HR}$-$U_{MR}$ mit einem als Zahlenwert vorliegenden, konstanten Spannungswert $U_K$ verglichen und daraus ein Faktor $U_K / (U_{HR}$-$U_{MR})$ zur Normierung des korrigierten Nutzsignals ($U_{sL}$-$\Delta U_{sL}$) gebildet. Auf diese Weise können Fehler korrigiert werden, die daraus resultieren, daß die Sinusspannungen $U_{e1}$ und $U_{e2}$ von dem vorgegebenen Wert abweichen, was sonst nur mit einem erheblich höheren Aufwand für die Konstanthaltung der Spannungsversorgung möglich wäre.

Mit dem beanspruchten Verfahren wird der bei herkömmlichen Meßmethoden mit der Verwendung von $U_s$ bzw. von $U_{se}$ verursachte Fehler vermieden, und es werden alle Einflüsse, die beim Meßsignal aufgrund fehlerhafter Ansteuerspannungen $U_{e1}$ und $U_{e2}$ verursacht werden, kompensiert. Damit erhält man ein Nutzsignal, das frei ist von Fehlern, die auf ungleichen ohmschen Widerständen oder nicht idealen Ansteuerspannungen beruhen.

**Patentansprüche**

1. Verfahren zum Betreiben eines induktiven Abstandssensors, bei dem
   - eine erste Spule mit einer gegen ein Nullpotential definierten Sinusspannung $U_{e1}$ und eine zweite, mit der ersten elektrisch in Reihe geschaltete und im Abstand zu dieser angeordnete Spule mit einer gleich großen, gegenphasigen Sinusspannung $U_{e2}$ beaufschlagt wird,
   - zwischen den Spulen eine Zunge angeordnet ist, die unter Einfluß einer Meßgröße das Verhältnis ihrer Abstände zu den Spulen und damit deren Induktivitäten $L_1$, $L_2$ ändert und
   - zwischen den Spulen eine Spannung $U_s$ gegen das Nullpotential als Nutzsignal abgegriffen wird,

dadurch gekennzeichnet, daß
   a) Realteil $U_{eR}$ und Imaginärteil $U_{eL}$ von $U_e$ = $U_{e1}$ + $U_{e2}$ hinsichtlich Größe und Phasenlage ermittelt werden,
   b) der mit $U_{eL}$ phasengleiche Anteil $U_{sL}$ von $U_s$ gemessen und
   c) der im Verhältnis $U_e/U_{eL}$ vergrößerte Wert von $U_{sL}$ für die Signalauswertung benutzt wird.

2. Verfahren zum Betreiben eines induktiven Abstandssensors, bei dem
   - eine erste Spule mit einer gegen ein Nullpotential definierten Sinusspannung $U_{e1}$ und eine zweite, mit der ersten elektrisch in Reihe geschalteten und im Abstand zu dieser angeordnete Spule mit einer gleich großen, gegenphasigen Sinusspannung $U_{e2}$ beaufschlagt wird,
   - zwischen den Spulen eine Zunge angeordnet ist, die unter Einfluß einer Meßgröße das Verhältnis ihrer Abstände zu den Spulen und damit deren Induktivitäten $L_1$, $L_2$ ändert und
   - zwischen den Spulen eine Spannung $U_s$ gegen das Nullpotential als Nutzsignal abgegriffen wird,

dadurch gekennzeichnet, daß
   a) ein Referenzsensor, bestehend aus einem ohmschen Präzisionswiderstandteiler, mit den Sinusspannungen $U_{e1}$ + $U_{e2}$ = $U_e$ beaufschlagt und die Mittelpunktspannung $U_M$ gegen das Nullpotential gemessen wird,
   b) der mit $U_{e1}$ polaritätsgleiche und mit $U_e$ phasengleiche Anteil $U_{MR}$ und der dazu um 90 Grad nacheilende Anteil $U_{ML}$ von $U_M$ ermittelt und abgespeichert werden, danach
   c) der Abstandssensor mit den Sinusspannungen $U_{e1}$ + $U_{e2}$ = $U_e$ beaufschlagt und von $U_e$ der Realteil $U_{eR}$ und der Imaginärteil $U_{eL}$ sowie der zugehörige Phasenwinkel $\alpha$ ermittelt werden,
   d) der mit $U_{e1}$ phasengleiche Anteil $U_{sL}$ von $U_s$ gemessen und schließlich
   e) $U_{sL}$ durch Subtrahieren von $\Delta U_{sL}$ = $U_{MR}$ x sin $\alpha$ + $U_{ML}$ x cos $\alpha$ korrigiert wird.

3. Verfahren nach Anspruch 1 oder 2, dadurch gekennzeichnet, daß die Nulldurchgänge des zu $U_e$ gehörenden Stroms $I_e$ zur Ermittlung des Realteils $U_{eR}$ und des dazu um 90 Grad phasenverschobenen Imaginärteils $U_{eL}$ von $U_e$ benutzt werden.

4. Verfahren nach Anspruch 1 oder 2, dadurch gekennzeichnet, daß die Nulldurchgänge von $U_e$ zur Ermittlung des zu $U_e$ phasengleichen und des dazu um 90° phasenverschobenen Stromanteils benutzt werden und daß aus den Stromanteilen der Winkel $\alpha$ der Phasenverschiebung zwischen $U_e$ und $I_e$ ermittelt und zur Bestimmung von $U_{eR}$ und $U_{eL}$ herangezogen wird.

5. Verfahren nach Anspruch 1 oder 2, <u>dadurch gekennzeichnet</u>, daß die Phasenverschiebung der Nulldurchgänge zwischen $U_e$ und $I_e$ als $\Delta t$ gemessen und der daraus ermittelte Winkel $\alpha$ zur Bestimmung von $U_{eR}$ und $U_{eL}$ herangezogen wird.

6. Verfahren nach einem der Ansprüche 1 bis 5, <u>dadurch gekennzeichnet</u>, daß das bei einer Temperatur $t_x$ gemessene Verhältnis $(U_{eL}/U_e)_x$ mit einem bei einer Referenztemperatur $t_0$ gemessenen Verhältnis $(U_{eL}/U_e)_0$ verglichen und dabei festgestellte Unterschiede zur Kompensation der Einflüsse temperaturabhängiger mechanischer Größen auf das Meßergebnis herangezogen werden.

7. Verfahren nach Anspruch 2, <u>dadurch gekennzeichnet</u>, daß an einem weiteren Abgriff H des Referenzsensors die Spannung $U_H$ gegen Nullpotential gemessen wird und daß deren mit $U_e$ phasengleicher Anteil $U_{HR}$, vermindert um $U_{MR}$, mit einer als Zahlenwertvorliegenden, konstanten Referenzspannung $U_K$ verglichen und zur Bildung eines Faktors $U_K / (U_{HR}-U_{MR})$ zur Normierung von $(U_{sL}-\Delta U_{sL})$ herangezogen wird.

## Claims

1. A method of operating an inductive distance sensor, wherein
   - a first coil is acted upon by a sinusoidal voltage $U_{e1}$ defined in relation to a zero potential and a second coil electrically connected in series with the first and disposed at a distance from the latter is acted upon by a sinusoidal voltage $U_{e2}$ of the same magnitude but in opposition of phase,
   - a tongue is disposed between the coils, which under the influence of a quantity to be measured alters the ratio of its distances from the coils and thus alters their inductances $L_1$, $L_2$, and
   - a voltage $U_s$ is tapped as the useful signal between the coils in relation to the zero potential,
   characterised in that
   a) the real part $U_{eR}$ and the imaginary part $U_{eL}$ of $U_e = U_{e1} + U_{e2}$ are determined with regard to their magnitude and phase position,

b) the component $U_{sL}$ of $U_s$ which is in phase with $U_{eL}$ is measured, and
c) the value of $U_{sL}$, increased in the ratio $U_e/U_{eL}$, is used for the signal evaluation.

2. A method of operating an inductive distance sensor, wherein
   - a first coil is acted upon by a sinusoidal voltage $U_{e1}$ defined in relation to a zero potential and a second coil electrically connected in series with the first and disposed at a distance from the latter is acted upon by a sinusoidal voltage $U_{e2}$ of the same magnitude but in opposition of phase,
   - a tongue is disposed between the coils, which under the influence of a quantity to be measured alters the ratio of its distances from the coils and thus alters their inductances $L_1$, $L_2$, and
   - a voltage $U_s$ is tapped as the useful signal between the coils in relation to the zero potential,
   characterised in that
   a) a reference sensor consisting of an ohmic precision resistance divider is acted upon by the sinusoidal voltages $U_{e1} + U_{e2} = U_e$ and the mid-point voltage is measured in relation to the zero potential,
   b) the component $U_{MR}$ of $U_M$, which is of the same polarity as and is in phase with $U_{e1}$, and the component $U_{ML}$ of $U_M$, which lags by 90 degrees in relation to component $U_{MR}$, are determined and stored, and thereafter
   c) the distance sensor is acted upon by the sinusoidal voltages $U_{e1} + U_{e2} = U_e$ and the real part $U_{eR}$ and the imaginary part $U_{eL}$ of $U_e$ and the associated phase angle $\alpha$ are determined,
   d) the component $U_{sL}$, which is in phase with $U_{eL}$, of $U_s$ is measured, and finally
   e) $U_{sL}$ is corrected by subtracting $\Delta U_{sL} = U_{MR} \times \sin \alpha + U_{ML} \times \cos \alpha$.

3. A method according to claim 1 or 2, characterised in that the zero crossing points of the current $I_e$ associated with $U_e$ are used for determining the real part $U_{eR}$ and the imaginary part $U_{eL}$, which is phase-shifted by 90 degrees in relation thereto, of $U_e$.

4. A method according to claim 1 or 2, characterised in that the zero crossing points of $U_e$ are used to determine the current component in phase with $U_e$ and the current component phase-shifted by 90° in relation thereto, and that the angle $\alpha$ of the phase shift between $U_e$

and $I_e$ is determined from the current components and is used for the determination of $U_{eR}$ and $U_{eL}$.

5. A method according to claim 1 or 2, characterised in that the phase shift of the zero crossing points between $U_e$ and $I_e$ are measured as $\Delta t$ and the angle $\alpha$ determined therefrom is used for the determination of $U_{eR}$ and $U_{eL}$.

6. A method according to any one of claims 1 to 5, characterised in that the ratio $(U_{eL}/U_e)_x$ measured at a temperature $t_x$ is compared with a ratio $(U_{eL}/U_e)_0$ measured at a reference temperature $t_0$ and differences thereby ascertained are used to compensate for the effects of temperature-dependent mechanical quantities on the measured result.

7. A method according to claim 2, characterised in that the voltage $U_H$ in relation to zero potential is measured at an additional tap H of the reference sensor, and that its component $U_{HR}$ which is in phase with $U_e$ is compared, reduced by $U_{MR}$, with a constant reference voltage $U_K$ which is present as a numerical value and is used to form a factor $U_K / (U_{HR}-U_{MR})$ for normalising $(U_{sL}-\Delta U_{sL})$.

**Revendications**

1. Procédé d'utilisation d'un capteur inductif de distance, dans lequel
   - une première bobine est soumise à l'action d'une tension alternative $U_{e1}$ définie par rapport au potentiel zéro et une seconde bobine, qui est connectée en série avec cette première et en est disposée à une certaine distance, est soumise à l'action d'une tension sinusoïdale $U_{e2}$ de même valeur et en opposition de phase avec la précédente ;
   - il est disposé entre ces bobines une languette qui, sous l'influence d'une grandeur mesurée, modifie le rapport de ses distances auxdites bobines et donc leurs inductances $L_1$ et $L_2$, et
   - une tension $U_s$ par rapport au potentiel zéro et représentant un signal utile, est prélevée entre les bobines,
   procédé caractérisé en ce que
   - on recherche la valeur et la position de phase de la composante réelle $U_{eR}$ et de la composante imaginaire $U_{eL}$ de $U_e$ = $U_{e1} + U_{e2}$ ;
   - on mesure la composante $U_{sL}$ de $U_s$ qui est en phase avec $U_{eL}$ ; et

   - on utilise pour exploiter le signal la valeur de $U_{sL}$ majoré dans le rapport $U_e/U_{eL}$.

2. Procédé d'utilisation d'un capteur inductif de distance, dans lequel
   - une première bobine est soumise à l'action d'une tension sinusoïdale $U_{e1}$ définie par rapport au potentiel zéro et une seconde bobine, qui est connectée en série avec cette première et qui est disposée à une certaine distance, est soumise à l'action d'une tension sinusoïdale $U_{e2}$ de même valeur et en opposition de phase ;
   - il est disposé entre ces bobines une languette qui, sous l'influence d'une grandeur mesurée, modifie le rapport de ses distances auxdites bobines et donc leurs inductances $L_1$, et $L_2$ ; et
   - une tension $U_s$ par rapport au potentiel zéro et représentant un signal utile est prélevée entre les bobines,
   procédé caractérisé en ce que
   a) - on soumet un capteur de référence, composé d'un diviseur de résistances ohmiques de précision, à l'action des tensions sinusoïdales $U_{e1} + U_{e2} = U_e$ et l'on mesure la tension $U_M$ par rapport au potentiel zéro au point central ;
   b) - on détermine et mémorise la composante $U_{MR}$ de $U_M$ qui a la même polarité que $U_{e1}$ et qui est en phase avec $U_e$ et la composante $U_{ML}$ qui la suit avec un retard de 90° ; puis
   c) - on soumet le capteur de distance à l'action des tensions sinusoïdales $U_{e1} + U_{e2}$ = $U_e$ et on recherche la composante réelle $U_{eR}$, la composante imaginaire $U_{eL}$ ainsi que l'angle de phase $\alpha$ de $U_e$ :
   d) - on mesure la composante $U_{sL}$ de $U_s$ qui est en phase avec $U_{e1}$ ; et enfin
   e) - on corrige $U_{sL}$ en en retranchant $\Delta U_{sL}$ = $U_{MR} \times \sin \alpha + U_{ML} \times \cos \alpha$.

3. Procédé selon la revendication 1 ou 2, caractérisé, en ce que l'on utilise les passages par zéro du courant $L_e$ qui fait partie de $U_e$ pour rechercher la composante réelle $U_{eR}$ et la composante imaginaire $U_{eL}$, qui en est déphasée de 90°, de $U_e$.

4. Procédé selon la revendication 1 ou 2, caractérisé en ce que l'on utilise les passages par zéro de $U_e$ pour déterminer la composante du courant qui est en phase avec $U_e$ et la composante de ce courant qui en est déphasée de 90°, on calcule au moyen de ces composantes du courant l'angle $\alpha$ de déphasage entre

$U_e$ et $I_e$, et l'on s'en sert pour déterminer $U_{eR}$ et $U_{eL}$.

5. Procédé selon la revendication 1 ou 2, caractérisé en ce que l'on mesure le déphasage entre les passages par zéro du $U_e$ et $I_e$, désigné par $\Delta t$, et l'on se sert de l'angle $\alpha$ qui en est déduit pour déterminer $U_{eR}$ et $U_{eL}$.

6. Procédé selon l'une des revendications 1 à 5, caractérisé en ce que l'on compare le rapport $(U_{eL}/U_e)_x$ mesuré à une température $t_x$ au rapport $(U_{eL}/U_e)_o$ mesuré à une température $t_o$ de référence et l'on se sert des différences constatées pour compenser l'effet sur le résultat de la mesure des grandeurs mécaniques dépendant de la température.

7. Procédé selon la revendication 2, caractérisé en ce que l'on mesure la tension $U_H$ par rapport au potentiel zéro à une autre prise H du capteur de référence, on compare sa composante $U_{HR}$ en phase avec $U_e$, diminuée de $U_{MR}$, avec une tension constante $U_K$ de référence exprimée numériquement, et l'on s'en sert pour former un facteur $U_K/(U_{HR}-U_{MR})$ destiné à normaliser $(U_{sL}-\Delta U_{sL})$.

**Fig.1**

**Fig.2**

EP 0 496 934 B1

Fig.3a

$U_{R1}$

$U_{L1}$

$U_{e1}$

5

$U_s$

$U_{sL}$

$U_{se}$

$U_{sR}$

$U_{e2}$

$U_{L2}$

$\alpha$

$U_{R2}$

Fig.3b

$U_{R1}$

$U_{L1}$

5

$U_s$

$U_{sL}$

$U_{e1}$

$U_{sR}$

$U_{se}$

$U_{e2}$

$U_{L2}$

$\alpha$

$U_{R2}$

10

Fig.4a

Fig.4b

Fig.4c

Fig. 5

Fig. 6

# Fig.7

Fig.8

**Fig.9b**

**Fig.9a**